# EUROPÄISCHE PATENTSCHRIFT

(11) **EP 0 530 190 B1**
(45) Veröffentlichungstag und Bekanntmachung des Hinweises auf die Patenterteilung: **07.09.1994**
(21) Anmeldenummer: 91900731.0
(22) Anmeldetag: 21.12.1990
(51) Int. Cl.: H05K 13/04

(54) **HILFSTRÄGER ZUM ÜBERTRAGEN VON TEILEN AUF EINEN TRÄGER UND VERFAHREN ZU DESSEN ANWENDUNG**
AUXILIARY CARRIER FOR TRANSFERRING PARTS ONTO A SUPPORTING PLATE AND PROCESS FOR USING THE SAME
SUPPORT AUXILIAIRE DE TRANSFERT DE PIECES A UN SUPPORT ET SON PROCEDE D'UTILISATION

(30) Priorität: 23.05.1990 DE 4016698
(43) Veröffentlichungstag der Anmeldung: 10.03.1993
(73) Patentinhaber: Siemens Nixdorf Informationssysteme Aktiengesellschaft, 33102 Paderborn (DE)
(72) Erfinder: EIDLING, Karl, D-8195 Egling (DE); BECKER, Michael, D-8014 Neubiberg0 (DE); KOHLER, Gerd, D-8000 München 19 (DE); EDINGER, Egon, D-8033 Krailling (DE)
(74) Vertreter: Fuchs, Franz-Josef, Dr.-Ing.
(86) Internationale Anmeldenummer: DE9001002
(87) Internationale Veröffentlichungsnummer: WO9118494

(56) Entgegenhaltungen:
- EP-A- 125 632
- WO-A-89/08927
- US-A- 4 893 403

## Beschreibung

Die Erfindung betrifft einen Hilfsträger und ein Verfahren zu dessen Anwendung, wobei Lötteile, die auf einem Träger positionsgenau fixiert werden sollen, zwischenzeitlich relativ zueinander justiert vom Hilfsträger aufgenommen werden und mittels diesem ebenfalls positionsgenau auf den Träger übertragbar sind.

Das positionsgenaue Aufbringen von Lötteilen auf einen Träger ist insbesondere bei der Herstellung von LED-Zeilen, wie sie in Zeichengeneratoren eingesetzt werden, von großer Bedeutung. Lichtemittierende Dioden (LEDs) werden dabei nicht zu Anzeigezwecken, sondern zu Druckzwecken eingesetzt. Zeichengeneratoren dieser Art gehören zur Kategorie der nichtmechanischen Drucker. Die Genauigkeit der Positionierung innerhalb der LED-Zeilen und relativ zu einem Träger muß in allen drei Raumrichtungen in der Größenordnung von ± 3 bis 10 µm liegen. Die Herstellung einer elektrisch leitenden und mechanisch tragenden Verbindung zwischen den LEDs und einem Träger, beispielsweise einer Modulplatte, kann durch Klebung oder durch Löten geschehen. Zur Gewährleistung der sicheren Ableitung der im Betrieb entstehenden Wärmemenge ist die Herstellung einer optimalen thermischen Ankoppelung zwischen LED und Modulplatte notwendig. Die aus diesem Grund angewandte Lötverbindung erfüllt einerseits diese Erfordernisse, hat jedoch gleichzeitig den Nachteil, daß aufwendige Justierungen erforderlich sind.

Aus der Patentanmeldung WO 89/08927 ist ein Verfahren zur Herstellung von LED-Zeilen, insbesondere für den Zeichengenerator eines nichtmechanischen Druckers bekannt. Durch die charakteristischen Eigenschaften der Herstellungsverfahren von LED-Bauteilen werden bestimmte maximale Längen dieser Bauteile nicht überschritten. Somit ist es zur Erstellung einer länglichen LED-Zeile notwendig, mehrere Bauteile mit gegenseitig genauer Positionierung hintereinander anzuordnen. Die Positionierung bezieht sich auf den Teilungsabstand, die Linientreue und die Ebenheit der gesamten Oberfläche der LED-Zeile. Dabei ist bekannt, daß beim Einsatz eines Lötverfahrens entsprechend enge Toleranzen durch den Einsatz eines Hilfsträgers zur zwischenzeitlichen Halterung der LEDs erzielbar sind. Die LEDs werden dabei zunächst mit Hilfe einer Bestückungsvorrichtung mit der Oberseite nach unten positionsgenau auf einen Hilfsträger geklebt. Der Kleber ist in der Regel thermisch und/oder durch ultraviolette Strahlung aushärtbar. Die so durch einzelne LED-Bauteile auf dem Hilfsträger zusammengesetzte LED-Zeile wird auf den mit Lot beschichteten Träger, in diesem Fall eine Modulplatte positioniert. Dabei wird die gesamte Anordnung fixiert, wobei die lötfähige Rückseite der LEDs das feste Lot auf der Modulplatte berührt. Nach dem erfolgten Umlöten der LED-Zeile auf die Modulplatte wird der Hilfsträger in einer Reihe von naßchemischen Prozessen wieder von der LED-Zeile abgelöst und gereinigt. Ebenso müssen die auf die Modulplatte gelöteten LEDs chemisch sowie mechanisch gereinigt werden. Die wesentlichen Nachteile eines derartigen Verfahrens bestehen in der komplizierten Klebetechnologie und in dem hohen Aufwand bezüglich der Fertigungseinrichtungen zur Bearbeitung des Hilfsträgers und der zwischenzeitlich aufgebrachten LED-Zeile.

Ein weiteres Verfahren zur Herstellung von LED-Zeilen ist aus dem Dokument US-A-4 893 403 bekannt.

Der Erfindung liegt die Aufgabe zugrunde, einen Hilfsträger und ein Verfahren bereitzustellen, womit die Lötpartner mit der geforderten Positionsgenauigkeit bei gleichzeitiger Einsparung von Arbeitsgängen und ohne chemische oder mechanische Reinigung des Hilfsträgers und der LED-Zeilen zusammengefügt werden können.

Die Lösung dieser Aufgabe wird durch die kennzeichnenden Teile des Anspruches 1 und des Anspruches 4 wiedergegeben.

Der Erfindung liegt die Erkenntnis zugrunde, daß ein mit Saugkammern ausgestatteter Hilfsträger, der als Saugträger bezeichnet wird, die positionsgenaue Ausrichtung der Lötteile bei gleichzeitig einfacher Handhabung gewährleistet. Dabei sind die einzeln ansteuerbaren und nebeneinander angeordneten Saugkammern im Saugträger derart ausgebildet, daß die jeweils angesaugten LEDs insgesamt eine LED-Zeile bilden. Durch den Einsatz eines solchen Saugträgers entfallen die nach dem Umlöten der Lötteile auf die Modulplatte notwendigen naßchemischen Prozesse zum Ablösen und zum Reinigen, sowie mechanische Reinigungsprozesse. Die Maßnahmen zum Ausrichten der einzelnen LED-Bauteile sind leicht durchführbar, wobei das korrekt ausgerichtete LED-Bauteil ohne Verschiebung oder Verdrehung durch Anlegen eines Vakuums an eine Saugkammer positionsgetreu fixiert wird.

Die Einstellung der Position eines LED-Bauteiles vor dem Fixieren am Saugträger geschieht mit einem beweglichen Übergabegreifer. Der anschließend in eine Vorrichtung zum Justieren der relativen Lage zwischen Saugträger und Träger und zum Umlöten der LED-Zeile auf die Modulplatte eingebrachte Saugträger wird innerhalb der Vorrichtung auf Federgelenken gelagert, und mit federunterstützten Spannelementen nach der Justierung an die Federgelenke angedrückt. Die Ausbildung der Federgelenke sieht eine erste vorbestimmte und bezüglich der Modulplatte beabstandete Position des Saugträgers vor, von der aus eine zweite der Modulplatte angenäherte Position durch den Einsatz verschiedener Abstandselemente innerhalb der Federgelenke erreichbar ist und über den Saugträger die LED-Zeile mit der beloteten Seite der Modulplatte zusammengefügt werden kann. Zu diesem Zeitpunkt ist das Lot bereits aufgeschmolzen, wodurch die LED-Zeile ohne mechanischen Belastungen in das Lot eintauchen kann. Nach der Erstarrung des Lotes wird der Saugträger lediglich durch Abschalten des Vakuums an den Saugkammern entfernt. Chemisches oder mechanisches Reinigen fällt hierbei nicht an.

Eine besondere Ausgestaltung der Erfindung sieht vor, daß der Hilfsträger beheizbar ist, wodurch Relativbewegungen der Teile aufgrund unterschiedlicher Temperaturen und unterschiedlicher thermischer Ausdehnungskoeffizienten vermieden werden. Die Justierung der einzelnen Lötteile untereinander und die des Saugträgers relativ zum Träger geschieht über im Saugträger vorhandene Durchgangsbohrungen. Dafür sind die Durchgangsbohrungen im Saugträger derart platziert, daß sie vorzugsweise Kanten, Ecken oder Marken der Lötteile erfassen.

Eine Weiterbildung des erfindungsgemäßen Verfahrens sieht vor, die Modulplatte, den Saugträger und den Übergabegreifer zu beheizen. Dadurch werden die Lageabweichungen der Teile vom Nennmaß wesentlich verringert.

Im folgenden wird anhand von schematischen Figuren ein Ausführungsbeispiel beschrieben.
- Figur 1 zeigt: die Frontansicht eines Saugträgers 2, der in eine Vorrichtung 10 eingespannt ist,
- Figur 2 zeigt: einen Saugträger 2 und einen Übergabegreifer in der Draufsicht,
- Figur 3 zeigt: einen Saugträger 2 mit angedeuteten, daran angesaugten LEDs 1, Durchgangsbohrungen 7 und Positioniermarken.

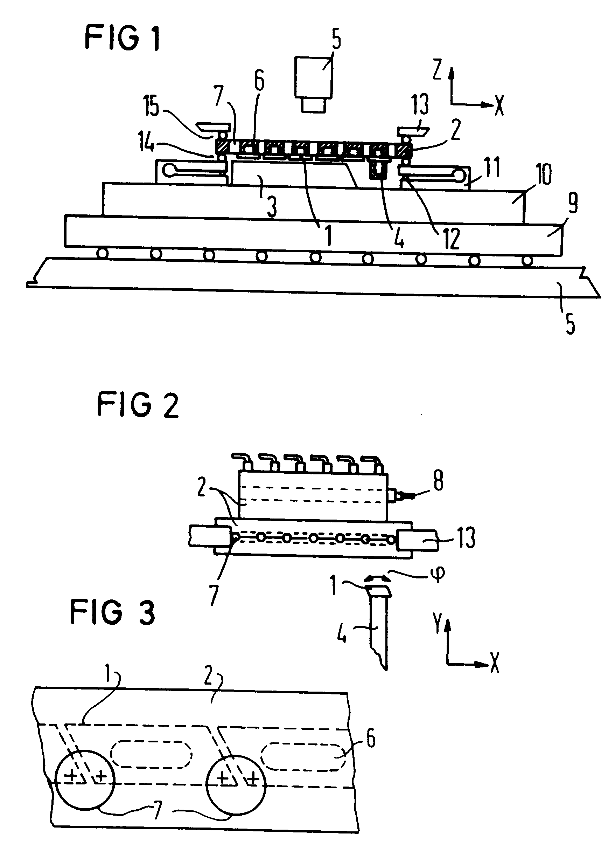

Die Figur 1 zeigt einen erfindungsgemäßen Saugträger 2, der in eine Vorrichtung 10 auf Federgelenke 11 und mittels Spannelementen 13 eingespannt ist. Dabei sind zum Ausgleich von Querkräften Rollen 14 und Kugeln 15 zwischengelagert. Die Spannelemente 13 sind federunterstützt gelagert. Der Schlitten 9 ist auf dem Grundkörper des Meßmikroskopes 5 gelagert und in der X, Y-Ebene in X-Richtung beweglich. Die Vorrichtung 10 nimmt ebenfalls die Modulplatte 3 auf.

Die Bestückung des Saugträgers 2 geschieht innerhalb dieser Einspannung, wobei mittels des Übergabegreifers 4, der in allen drei Raumrichtungen beweglich und um die Z-Achse drehbar ist, so daß er die auf ihn abgelegten LEDs 1 unter dem Saugträger einzeln positionieren und ausrichten kann. Der Übergabegreifer 4 arbeitet in diesem Fall ebenfalls mit einer Saugkammer, wodurch er die LEDs 1 während des Verfahrens durch Unterdruck halten kann. Der Übergabegreifer 4 ist mit einer geregelten Heizung versehen, mittels derer er ungefähr auf die Temperatur des beheizten Saugträgers 2 aufgeheizt wird. Die einzeln ansteuerbaren Saugkammern 6 halten die LEDs 1, nachdem sie über die Durchgangsbohrungen 7 und das Meßmikroskop 5 mittels vorhandener Marken ausgerichtet wurden. Da der Saugträger 2 ebenfalls eine geregelete Heizung besitzt, wird bei der Übergabe der LEDs 1 vom Übergabegreifer 4 zum Saugträger 2 keinerlei Temperatursprung erzeugt. Die bisher angelegte Temperatur liegt etwas unterhalb der Schmelztemperatur des Lotes. Ist der Saugträger 2 vollständig bestückt, so werden die ebenfalls beheizte Modulplatte 3 und der Saugträger 2 auf Löttemperatur aufgeheizt, bis das Lot auf der Modulplatte 2 schmilzt. Danach wird der Saugträger 2 mit Hilfe der Vorrichtung 10 auf die Modulplatte 3 abgesenkt. Durch geeignete Temperaturregelung wird erreicht, daß sich Saugträger 2 und Modulplatte 3 reproduzierbar abkühlen. Nach dem Unterschreiten der Schmelztemperatur des Lotes wird die Saugluft des Saugträgers 2 abgeschaltet. Knapp unterhalb des Schmelzpunktes kann bei geregelter Temperaturführung die LED-Zeile bereits vermessen werden. Die Bezugsbasis hierfür ist nach wie vor die definiert in die Vorrichtung 10 eingespannte Modulplatte 3, wobei eine achsparallele Ausrichtung bezüglich der Y-Richtung zweckmäßig ist, die bei der Bestückung am Übergabegreifer 4 und am Saugträger 2 eingestellte Temperatur sorgt dafür, daß keine Relativbewegungen der LEDs 1 aufgrund unterschiedlicher Temperaturen und unterschiedlicher thermischer Ausdehnungskoeffizienten stattfindet. Außerdem wird beim Erhöhen auf Löttemperatur durch eine geringe Temperaturdifferenz nur eine geringe Relativbewegung der LEDs 1 auf dem Saugträger 2 hervorgerufen. Ähnliches gilt für die vorverzinnte Modulplatte 3, die ebenfalls frühzeitig auf eine knapp unter der Löttemperatur liegende Temperatur vorgeheizt wird.

Das Absenken des Saugträgers 2 aus einer ersten beabstandeten Position von der Modulplatte 3 in eine zweite bezüglich der Modulplatte 3 angenäherte Position wird durch die Wirkung verschiedener Abstandselemente 12, die in den Federgelenken 11 eingebracht sind, begrenzt. Eine einfache Kombination besteht unter anderem aus Schmelzelementen, die die Federgelenke 11 derart beabstanden, daß zwischen Saugträger 2 und Modulplatte 3 die erste Position eingestellt ist. Diese Schmelzelemente sind durch Auswahl ihrer Schmelztemperatur und ihrer Masse so eingestellt, daß sie kurz nach dem Aufschmelzen des Lotes auf der Modulplatte 3 abschmelzen. Die zweite Position, bei der die LEDs 1 und die Modulplatte 3 zusammengefügt sind, kann beispielsweise durch feste Anschläge innerhalb der Federgelenke 11 vorgegeben sein. Die federunterstützten Spannelemente 13, die in der Lage sind, die Federgelenke 11 zusammenzudrükken, sorgen in Verbindung mit den verschiedenen Abstandselementen 12, insbesondere mit Schmelzelementen, für ein gleichmäßiges Zusammenfügen der Lötpartner.

Die Beschaffenheit der Oberfläche des Saugträgers 2 ist in der Regel eben. Der Saugträger 2 kann jedoch auf der Seite, an der die LEDs 1 angesaugt werden, derart profiliert sein, daß auch LEDs 1 ansaugbar sind, die in der Längsachse extrem durchgebogen sind. Der Übergabegreifer 4 kann zusätzlich mit Greifbacken ausgerüstet sein, um bereits am Saugträger 2 angesaugte LEDs 1 zu manipulieren. Die Bezugsbasis ist jeweils die Position der Modulplatte 3, die innerhalb der Vorrichtung 10 zweckmäßigerweise in Y-Richtung ausgerichtet ist.

In der Figur 2 sind in der Draufsicht der Saugträger 2 mit dem Anschluß der internen Heizung 8 dargestellt. Es werden die Durchgangsbohrungen 7 gezeigt und ein Teil der LED-Zeile ist angedeutet. Von den federunterstützten Spannelementen 13 sind lediglich die Auflagezungen eingezeichnet. Auf dem Übergabegreifer 4 ist ein LED 1 per Hand aufgelegt worden, wobei eine Ausrichtung durch Verfahren des Übergabegreifers 4 in alle drei Raumrichtungen, sowie durch ein Verdrehen entsprechend dem Kippwinkel φ möglich ist.

Die Figur 3 zeigt einen Saugträger 2 mit angedeuteten LEDs 1 und Saugkammern 6. An den Ecken der LEDs 1 sind in diesem Fall kreuzförmige Marken zur Justierung vorhanden, wodurch mittels des Meßmikroskopes 5 über die am Saugträger vorhandenen Durchgangsbohrungen 7 die relative Ausrichtung der LEDs 1 untereinander möglich ist. Entsprechendes gilt für die Ausrichtung des Saugträgers 2 in bezug auf die darunterliegende sichtbare Modulplatte 3.

Durch den Einsatz eines erfindungsgemäßen Saugträgers 2 zusammen mit dessen gezielt steuerbarer Absenkbewegung zum Fügen der Lötpartner läßt sich das Löten von LEDs 1 auf eine Modulplatte 3 weitestgehend kontrollieren. Der Prozess kann zur Automatisierung rechnergesteuert werden. Besondere Vorteile ergeben sich durch die jederzeit durchführbaren Eingriffsmöglichkeiten. Dabei können entstandene Positionsfehler auf dem Saugträger 2 sofort korrigiert werden, das Lötergebnis ist schnellstens meßbar und die Lageabweichungen der LEDs 1 von einem Nennmaß können dadurch minimiert werden. Aus diesen Gründen und durch den Wegfall bisher notwendiger Verfahrensschritte, wie - Kleben, chemische Behandlung zum Ablösen und Reinigen und mechanische Reinigung - wird die Ausbeute des Verfahrens wesentlich erhöht. Die Fertigungszeiten sind durch einen automatischen Prozessablauf um ca. 60 % reduzierbar. Eine Fluorchlorkohlenwasserstoffatmosphäre (FCKW), wie sie beispielsweise bei einer Dampfphasenlötanlage eingesetzt wird, entfällt. Der gesamte Montage- und Lötvorgang kann an einem Arbeitsplatz und in einer Aufspannung ablaufen.

## Patentansprüche

1. Hilfsträger zur Übertragung von Lötteilen auf einen Träger, wobei die Teile zwischenzeitlich auf dem Hilfsträger lösbar und in positionsgenauer Ausrichtung fixierbar sind, insbesondere zur Herstellung von LED-Zeilen, **dadurch gekennzeichnet**, daß der Hilfsträger ein Saugträger (2) mit einzeln ansteuerbaren, den zu übertragenden Lötteilen jeweils zugeordneten, Saugkammern (6) ist.

2. Hilfsträger nach Anspruch 1, **dadurch gekennzeichnet**, daß der Hilfsträger beheizbar ist.

3. Hilfsträger nach Anspruch 1 oder 2, **dadurch gekennzeichnet**, daß der Hilfsträger Durchgangsbohrungen (7) zur Justierung der zu übertragenden Lötteile aufweist.

4. Verfahren zum positionsgenauen Übertragen von Lötteilen auf einen Träger unter Verwendung eines Hilfsträgers nach einem der Ansprüche 1 - 3, **dadurch gekennzeichnet**, daß
- die zu übertragenden Lötteile mittels eines beweglichen Übergabegreifers (4) auf dem Saugträger (2) positioniert, zueinander ausgerichtet und mittels Vakuum an den Saugkammern (6) des Saugträgers gehalten werden,
- der auf Federgelenken (11) gelagerte Saugträger (2) in Richtung der zu übertragenden Lötteile durch eine von Spannelementen (13) auf den Saugträger (2) aufgebrachten Kraft aus einer ersten vorbestimmten und bezüglich einer Modulplatte (3) beabstandeten Position in eine zweite vorbestimmte und der Modulplatte (3) angenäherte Position bewegt wird, wobei die einzelnen Positionen durch verschiedene Abstandselemente (12) innerhalb der Federgelenke (11) definiert sind und in der zweiten Position die Lötteile auf die Modulplatte (3) übertragen werden,
- der Saugträger (2) durch Abschalten des Vakuums in den Saugkammern (6) entfernt wird.

5. Verfahren nach Anspruch 4, **dadurch gekennzeichnet**, daß die Modulplatte (4), der Saugträger (2) und der Übergabegreifer (4) beheizt werden.

## Claims

1. Auxiliary carrier for transferring soldering parts onto a carrier, in which the parts can be fixed temporarily on the auxiliary carrier in a detachable manner and with an exact position alignment, preferably for the production of LED rows, characterized in that the auxiliary carrier is a suction carrier (2) with individually controllable suction chambers (6) assigned to the soldering parts to be transferred in each case.

2. Auxiliary carrier according to Claim 1, characterized in that the auxiliary carrier can be heated.

3. Auxiliary carrier according to Claim 1 or 2, characterized in that the auxiliary carrier has throughholes (7) for aligning the soldering parts to be transferred.

4. Method for the exactly positioned transfer of soldering parts onto a carrier using an auxiliary carrier according to one of Claims 1 - 3, characterized in that
- the soldering parts to be transferred are positioned on the suction carrier (2) by means of a movable transfer grab (4), aligned with one another and held against the suction chambers (6) of the suction carrier by means of a vacuum,
- the suction carrier (2) mounted on spring joints (11) is moved in the direction of the soldering parts to be transferred by means of a force applied to the suction carrier (2) by clamping elements (13) from a first predetermined position which is at a distance with respect to a modular plate (3) into a second predetermined position which is nearer to the modular plate (3), the individual positions being defined by various spacer elements (12) within the spring joints (11), and the soldering parts being transferred onto the modular plate (3) in the second position,
- the suction carrier (2) is removed by switching off the vacuum in the suction chambers (6).

5. Method according to Claim 4, characterized in that the modular plate (3), the suction carrier (2) and the transfer grab (4) are heated.

## Revendications

1. Support auxiliaire de transfert de pièces à braser sur un support, les pièces pouvant être fixées intermédiairement sur le support auxiliaire, de façon amovible et avec un alignement précis en position, notamment pour la fabrication de lignes de diodes LED, caractérisé par le fait que le support auxiliaire est un support aspirant (2) comportant des chambres d'aspiration (6) qui peuvent être commandées individuellement et qui sont associées respectivement aux pièces à braser à transférer.

2. Support auxiliaire suivant la revendication 1, caractérisé par le fait qu'il peut être chauffé.

3. Support auxiliaire suivant la revendication 1 ou 2, caractérisé par le fait qu'il possède des perçages (7) destinés à ajuster les pièces à braser à transférer.

4. Procédé pour transférer, d'une manière précise en position, des pièces à braser à un support en utilisant un support auxiliaire suivant l'une des revendications 1 à 3, caractérisé par le fait que
- les pièces à braser à transférer sont mises en position, au moyen d'un dispositif mobile de préhension (4) pour le transfert, sur le support aspirant (2), sont alignées entre elles et sont maintenues par le vide contre les chambres d'aspiration (6) du support aspirant,
- le support aspirant (2) monté sur des articulations à ressorts (11) est déplacé, en direction des pièces à braser à transférer, sous l'action d'une force appliquée par des éléments de blocage (13) au support aspirant (2), d'une première position prescrite et, à distance d'une plaque porte-modules (3), à une seconde position prescrite, rapprochée de la plaque porte-modules (3), les positions étant définies par différentes entretoises (22) à l'intérieur des articulations à ressorts (11), et, dans la seconde position, les pièces à souder sont transférées à la plaque porte-modules (3),
- le support aspirant (2) est retiré par suppression du vide dans les chambres aspirantes (6).

5. Procédé suivant la revendication 4, caractérisé par le fait que la plaque porte-modules (4), le support aspirant (2) et le dispositif de préhension (4) pour le transfert sont chauffés.
